Europäisches Patentamt

European Patent Office

Office européen des brevets

(11) Publication number: **0 421 498 A2**

# EUROPEAN PATENT APPLICATION

(21) Application number: 90201910.8

(51) Int. Cl.⁵: **B01L 1/02**

(22) Date of filing: 13.07.90

The title of the invention has been amended (Guidelines for Examination in the EPO, A-III, 7.3).

(30) Priority: 11.09.89 IT 4835189

(43) Date of publication of application:
10.04.91 Bulletin 91/15

(84) Designated Contracting States:
CH DE FR GB LI NL SE

(71) Applicant: CONSORZIO CE.TE.V. CENTRO TECNOLOGIE DEL VUOTO
Via Turanense, Km. 44,452
I-67061 Carsoli (L'Aquila)(IT)

(72) Inventor: Misiano, Carlo
Via G.B. Morgagni, 22
I-00161 Roma(IT)
Inventor: Simonetti, Enrico
Viale Marconi, 112
I-00146 Roma(IT)

(54) **Device for the rapid loading of substrates or other articles into vacuum plants.**

(57) Device for the speedy loading of substrates in the vacuum plants, made up by a small fore-chamber of restricted dimensions, evacuable, equipped with an opening towards the atmospheric ambient and an opening towards the deposition chamber.

The invention places itself in the componentistic field for vacuum plants.

For its best application must be associated to a vacuum chamber and can be advantageously used for deposition processes of thin layers. With this device, the working cycles become more speedy and capable to carry out different and simultaneous treatments of one or more samples even at different conditions, keeping the vacuum chamber at the pressure and the purity wanted.

Such device can be applied to any vacuum chamber and/or to any chamber for treatments.

Sez. A

FIG. 2

EP 0 421 498 A2

# DEVICE FOR THE SPEEDY LOADING UP OF SUBSTRATES OR OTHERS, IN THE VACUUM PLANTS.

The present invention concerns a device for the speedy loading of samples in the vacuum plants and finds its best application in laboratories where setting up operations and processes for deposition and treatment both for research and production are carried out.

The invention is essentially configurated by a fore-chamber applied to the wall of any vacuum chamber.

The aforesaid fore-chamber is equipped of a closing plate supplied with concave or flat slots, that are to contain the substrates to be treated. The substrates, once laid in the fore-chamber, will be introduced into the vacuum chamber simply by rotating the above closing plate.

It means that the evacuating process is carried out only in the fore-chamber which is of reduced dimensions, whilst the vacuum chamber, once evacuated, it will be utilized for a long period, not being forced to carry out an operation of evacuation after each cycle of treatment.

According to the traditional techniques, the "carry out" process was as follows:
- Loading in the vacuum chamber one or more substrates that have to be treated in different conditions according to the setting up of the process.
- On conclusion of treatments, it started the successive cycle during which it had to be opened the vacuum chamber (this one returned to be atmospheric pressure).
- Utilizing a fore-chamber of conventional type that allowed, after its evacuation, to insert the sample or samples, through its mechanical movementation.
- As results from the above old process, there were idle times during which the deposition operation was not working, or else, it was necessary to use very expensive equipments.
- Consequently, idle times and scarce versatility, particularly during research phases and setting up of the processes where the most evident inconvenients encountered in the previous solutions. Besides it was not always possible, even at higher expenses, to insert fore-chamber to old plants.

The presented invention resolves all the aforesaid inconvenients with a simple mechanical solution that permits a rapid passage from the fore-chamber to the vacuum chamber, through the rotation of the plate on which the pieces to be treated are placed.

It is very important to specify that the aforesaid inconvenients is described in the actual version preferred by the inventors, but following the same philosophy, it can be realized with differentiated configurations as far as it fits to any chamber for chemical-physics processes, etc. both definitively and temporarly.

Besides, the fore-chamber evacuation, suitable connected, can be achieved with the same pumping machine that cares the evacuation of the vacuum chamber.

Such device have to be considered a vacuum fore-chamber, known in the specific language with the English expression "Load Lock" is now described as aim illustrative and not restrictive, referring to the enclosed drawing tables:

Fig.1 represents a lateral view of a vacuum chamber with the device (fore-chamber) object of the presented invention, applied to the upper side.

Fig.2 must be considered the most significant figure, it relates in detail the section (a) elements of the apparatus in which are visible:

1 External apparatus body.
1A Cover.
2 Rotary feed-through.
3 Pumping hole.
4 Hinge
5 Communication hole to the chamber.
6 Sealing "O-Ring"
7 Chamber structure.
8 Rapid enclosure coupler.
9 Enclosure plate and substrates holder.
10 Substrates holder housing.
11 Connection hole with the chamber.
12 fastening holes.

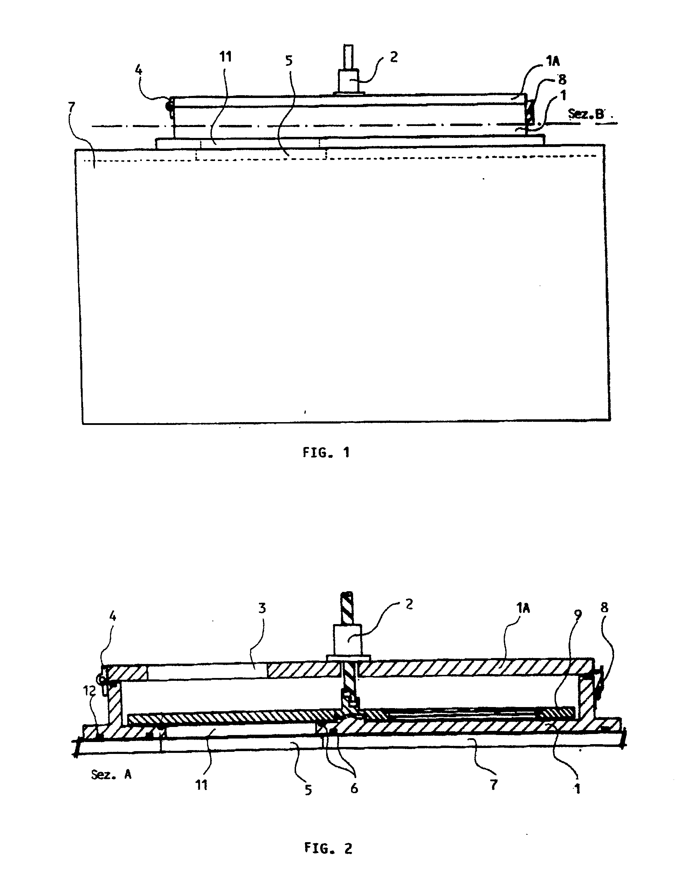

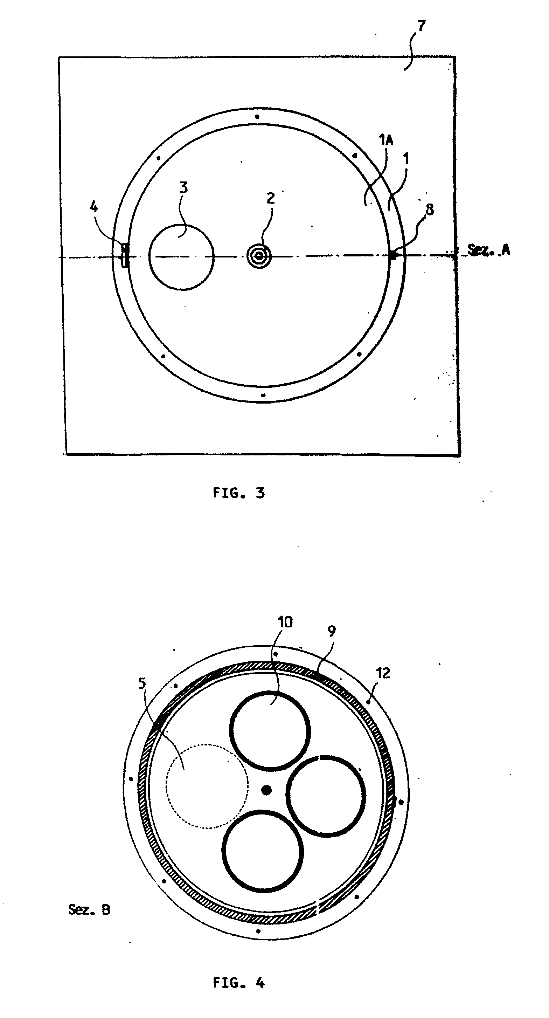

Fig.3 gives a view from the top of the closing plate, in which are visible other parts intuitively recognisable in the Fig.1 Details:

1A Cover.
1 External body apparatus.
2 Rotary feed-through.
3 Pumping hole.
4 Hinge.
8 Rapid enclosure coupler.

Fig.4 represents the denominated "plate for enclosure and substrates holder" rotary, indicated with (9) at Fig.2 in which are visible:

5 Hole placed below the rotary plate that when is not visible causes the sealing enclosure.
10 Substrates holder housing.
12 Holes for the clamping screws when the sides are not welded.

As afore-cited it shows the simplicity concerning the operation of the presented system, in fact; the substrates are placed in the housing (10) assigned by the fore-chamber; the enclosure plate (9) rotates to place itself for every cycle the required time, on the communication chamber hole (5); once terminated the cycle, process continues immediately to the next substrate and so on.

The processing starts without requiring that the vacuum chamber returns to the atmospheric pressure.

The fore-chamber advantages, subject of the invention, are various manifolds; herewith are listed some of the most significatives

: - It may be considered an external apparatus that can be applied (taken away) to (from) any vacuum plant.

- It is applicable to any vacuum plant or others similar.

- it is particularly suitable for the set up of processes.

- If it is equipped with an opportune connection can be vacuumed by the same pumping system that cares to evacuate the vacuum chamber.

- It can be used too as differential pumping chamber to analyze the gaseous residual on the environment.

- It can be associated easily to a vacuum chamber or similar, even for a short period, then removed. It means that the same device, can be utilized for more vacuum chambers or similars.

## Claims

1) Device for the speedy loading up of substrates in the vacuum plants or similars to be applied to a vacuum chamber, characterized by the fact of being essentially constituted with a fore-chamber having an opening towards the atmospheric ambient and another (11) towards the deposition chamber, equipped of a closing plate (9) supplied with concave slots (10) either flat or any other shape preset to contain the substrates to be treated.

2) Device for the speedy loading up of substrates in the vacuum plants or similars to be applied to a vacuum chamber, characterized by the fact of being constituted with an element (Sec.A) that has got at the same time the function of housing the substrate and exposing it to the vacuum chamber, being all rotating on a pin.

3) Device for the speedy loading up of substrates in the vacuum plants or similars to be applied to a vacuum chamber, as by claim 1, characterized by the fact of being applicable to any vacuum chamber.

FIG. 1

FIG. 2

EP 0 421 498 A2

FIG. 3

Sez. B

FIG. 4

5